Europäisches Patentamt

European Patent Office

Office européen des brevets

(19)

(11) Numéro de publication: **0 031 260**
**B1**

## (12) FASCICULE DE BREVET EUROPEEN

(45) Date de publication du fascicule du brevet: **23.11.83**

(21) Numéro de dépôt: **80401616.0**

(22) Date de dépôt: **12.11.80**

(51) Int. Cl.³: **H 01 L 21/76,**
H 01 L 21/306

(54) **Procédé d'alignement de photogravures par rapport aux murs d'isolement de caisson dans des circuits intégrés.**

(30) Priorité: **21.12.79 FR 7931483**

(43) Date de publication de la demande:
**01.07.81 Bulletin 81/26**

(45) Mention de la délivrance du brevet:
**23.11.83 Bulletin 83/47**

(84) Etats contractants désignés:
**DE FR GB IT**

(56) Documents cités:
**DE - A - 2 633 134**
**US - A - 3 954 523**
**US - A - 4 016 017**

**IBM TECHNICAL DISCLOSURE BULLETIN, vol.
20, no. 6, novembre 1977 New York, US G. LEE:
"Self-aligning subcollector and isolation regions
in a semiconduction transistor", pages 2233-
2234**

(73) Titulaire: **THOMSON-CSF**
**173, Boulevard Haussmann**
**F-75379 Paris Cedex 08 (FR)**

(72) Inventeur: **Tonnel, Eugène**
**"THOMSON-SCF" SCPI 173, bld Haussmann**
**F-75360 Paris Cedex 08 (FR)**

(74) Mandataire: **de Beaumont, Michel et al,**
**THOMSON-CSF SCPI 173, Bld Haussmann**
**F-75379 Paris Cedex 08 (FR)**

Courier Press, Leamington Spa, England.

## Procédé d'alignement de photogravures par rapport aux murs d'isolement
## de caisson dans des circuits intégrés

La présente invention concerne un procédé d'alignement de photogravures par rapport aux murs d'isolement de caissons dans des circuits intégrés et des structures intégrées incorporant de tels caissons. Elle s'applique plus particulièrement aux circuits intégrés bipolaires dans lesquels l'épaisseur de la couche épitaxiale est de l'ordre de quelques microns seulement.

De façon générale, dans la technique des circuits intégrés bipolaires, chaque composant élémentaire du circuit intégré est formé à l'intérieur d'un caisson destiné à assurer le fonctionnement de ce composant indépendamment des phénomènes pouvant se produire dans les zones correspondant aux composants voisins.

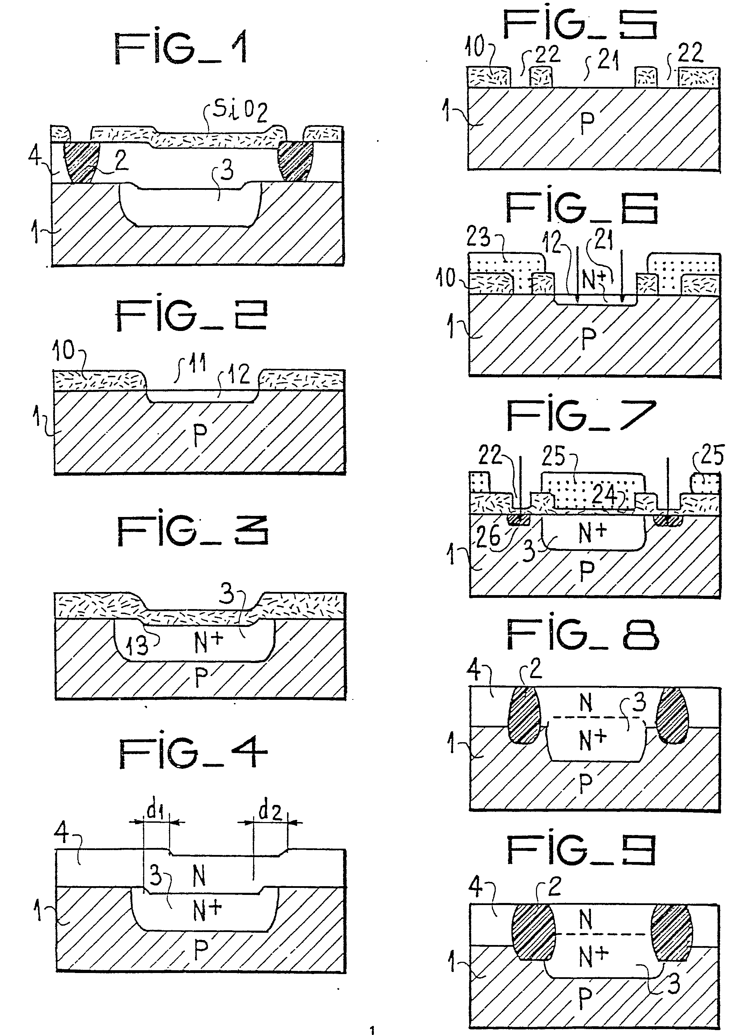

La figure 1 représente un caisson de circuit intégré bipolaire obtenu de façon classique. Ce caisson est formé sur un substrat de semiconducteur, couramment du silicium désigné par la référence 1. Il est délimité latéralement par une zone 2 de type $P^+$ ayant un contour fermé, couramment de forme carré ou rectangulaire. Entre la partie inférieure du caisson et le substrat 1 est fréquemment formée une couche enterrée 3 du même type de conductivité que le caisson, et du type de conductivité opposé à celui du substrat, par exemple de type $N^+$ si le substrat est du type P et le caisson de type N.

De façon classique, ce caisson, de type N, est formé en implantant initialement dans le substrat P, sensiblement aux emplacements de la couche destinée à devenir la couche enterrée 3, des impuretés dopantes à concentration élevée, puis en faisant croître une couche épitaxiale 4 sur le substrat et enfin en effectuant à travers un masque approprié une diffusion pour former les murs d'isolement 2 du caisson.

L'une des difficultés technologiques qui se pose lors de la fabrication de caissons décrits ci-dessus en relation avec la figure 1, réside dans le fait que, une fois que la couche enterrée 3 a été formée puis que la couche épitaxiale 4 a été amenée à croître, un ne ''voit'' pas les emplacements de la couche enterrée 3 à partir de la surface supérieure du substrat. Il est donc très difficile de positionner le masque destiné à localiser la diffusion des murs d'isolement pour l'aligner sur le masque ayant servi à la formation de la couche enterrée 3.

Divers procédés ont déjà été imaginé antérieurement pour essayer de résoudre ce problème.

L'un des procédés connus consiste, comme cela est représenté en figure 2, à graver dans une couche d'oxyde 10 formée à la surface du substrat 1 des ouvertures 11 dans lesquelles seront implantées les couches enterrées 12 de type $N^+$. Dans un deuxième temps représenté sur la figure 3, on effectue un traitement thermique à température élevée en atmosphère légèrement oxydante. Durant cette opération la croissance de la couche de silice plus rapide au niveau du silicium apparent de la couche enterrée provoque une dépression dans la surface du silicium au-dessus de cette couche enterrée. Cette dénivellation fait apparaître une marche 13 qui délimite la périphérie de la couche enterrée. L'orientation de cette marche étant différente du reste de la surface du substrat et la croissance épitaxiale étant anisotrope, la croissance du silicium va s'effectuer d'une façon oblique par rapport à la marche.

On obtiendra alors à la surface de la couche épitaxiée, comme représentée figure 4, une image de la dépression qui ne sera plus à l'aplomb de celle effectuée dans le substrat. De plus, l'orientation cristalline des facettes en regard étant différente, les déplacements $d_1$ et $d_2$ qu'elles subiront le seront aussi et l'image de la dépression à la surface sera non seulement déplacée mais encore déformée.

Bien qu'il soit possible, pour des conditions de croissance épitaxiale rigoureusement contrôlées d'obtenir des déplacements et des déformations reproductibles, il apparaît que cette méthode ne permet pas d'obtenir une grande précision dans l'alignement de la gravure qui définira les murs d'isolement par rapport à la couche enterrée sous-jacente. Pratiquement, en ten ant compte d'un déplacement constant pour des conditions données de croissance, il n'est pas possible d'assurer cet alignement avec une précision supérieure à 1 $\mu$ et ceci pour des couches épitaxiées n'excédant pas 3 $\mu$ d'épaisseur.

Un autre procédé de l'art antérieur pour positionner le masque d'isolement par rapport à la couche enterrée consiste à prendre un repère sur la face arrière du substrat Ce repère réalisé lors de la gravure de la couche enterrée nécessite une face arrière polie optique pour que sa définition géométrique soit suffisante lors de l'alignement. Mais avec les méthodes utilisées la précision est encore moins bonne que précédemment et est d'autant plus mauvaise que la plaquette est épaisse ce qui, limite son emploi aux plaquettes de faible diamètre ou aux dispositifs de puissance dont l'alignement est peu critique.

Ainsi, un objet de la présente invention est de pallier les inconvénients exposés ci-dessus de l'art antérieur et de prévoir un procédé de formation de caisson permettant un alignement extrêmement précis des murs d'isolement par rapport à la couche enterrée d'un circuit intégré.

Pour atteindre cet objet, la présente invention prévoit un procédé d'alignement des photogravures effectuées dans chaque caissson par rapport aux murs d'isolement de caissons dans des circuits intégrés, ces caissons étant formés dans une couche (4) d'un premier type de conductivité d'une épaisseur de 1 à 3 microns obtenue par croissance épitaxiale sur un substrat (1) du deuxième type de conductivité dans lequel sont implantées dans des zones correspondant au fond des caissons, des impuretés dopantes (12) du premier type de conductivité, ces caissons étant limités latéralement par des murs d'isolement; ce procédé consistant à implanter des impuretés dopantes (26) du deuxième type de conductivité dans le substrat selon le contour des murs d'isole-ment, puis, après formation de la couche épitaxiale, à faire diffuser ces impuretés vers et jusqu'à la surface de la couche épitaxiée, comprenant en outre l'étape consistant à rendre visible la zone d'affleurement supeficielle des murs d'isolement.

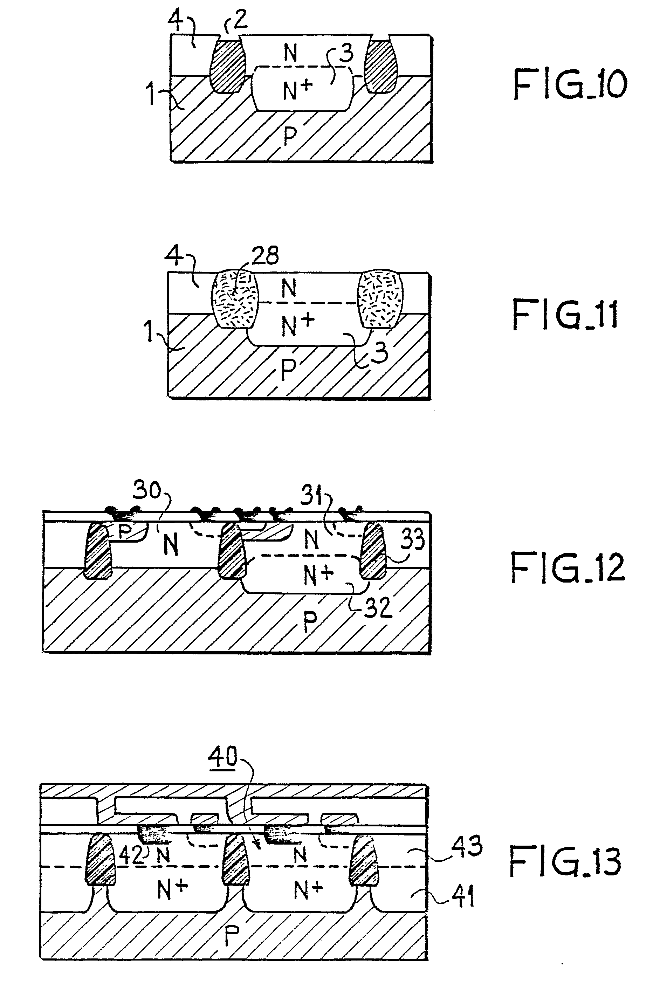

Un mode de réalisation consiste à anodiser les plaquettes pour transformer les murs d'isolement en silicium monocristallin dopé du même type de conductivité que le substrat en silicium poreux, puis à procéder à un traitement oxydant pour transformer le silicium poreux en silice (Fig. 11).

Un autre mode de réalisation consiste à soumettre la surface de la plaquette à une attaque chimique, sélective selon le type de conductivité (Fig. 10).

On notera que le brevet US 3 954 523 décrit la formation de murs d'isolement diélectrique par anodisation puis oxydation à partir d'une zone implantée puis exodiffusée à travers une couche épitaxiale très mince, d'épaisseur inférieure à un micron et que le brevet US 4 016 017 enseigne des procédés d'anodisation de silicium et d'oxydation de silicium poreux, à partir de murs diffusés p$^+$ ainsi que leur application à la formation de murs d'isolement diélectrique dans des circuits intégrés. Aucun de ces documents ne suggère de rendre visible le faîte de murs d'isolement eux-mêmes convenablement alignés pour permettre un alignement satisfaisant de masques de diffusion ultérieurs.

Ces objets, caractéristiques et avantages ainsi que d'autres de la présente invention seront exposés plus en détail dans la description suivante de modes de réalisation particuliers faite en relation avec les figures jointes parmi lesquelles:

Les figures 1 à 4 ont été décrites précédemment et étaient destinées à illustrer l'état de l'art antérieur;

Les figures 5 à 11 illustrent des étapes du procédé de formation de caisson selon la présente invention; et

Les figures 12 et 13 représentent des applications de la présente invention.

La figure 5 illustre une première étape du procédé de la présente invention. Comme dans le procédé de l'art antérieur, on utilise par exemple un substrat 1 de type P que l'on soumet à une oxydation thermique.

A la différence du cas précédant, on grave dans la couche de silice 10, en une seule opération, deux types d'ouvertures au lieu d'un. Dans les ouvertures 21 seront diffusées les couches enterrées N$^+$ et dans les ouvertures 22 on formera ultérieurement les fondations des murs d'isolement.

Le masque photographique utilisé comporte les motifs correspondant aux couches enterrées et aux murs d'isolement. La position relative des deux régions est donc définie par la définition photographique du masque; elle est actuellement de l'ordre de 0,1 $\mu$.

Dans une deuxième étape représentée en figure 6, on étale sur la couche de silice 10 et ses ouvertures 21 et 22 une couche 23 d'une laque ou résine photo-sensible, cette couche est ensuite impressionnée à travers un masque comportant uniquement les motifs de la couche enterrée. Ces motifs sont légèrement agrandis, de 2 $\mu$ par exemple, de façon à permettre leur alignement par rapport aux motifs précédemment gravés.

La résine, alors développée, dégage les ouvertures 21 tout en obstruant les ouvertures 22. On procède ensuite à l'implantation du dopant pour former la couche enterrée 12. L'implantation d'une dose d'arsenic de $5 \times 10^{15}$ at/cm$^2$ avec une énergie de 100 keV permet, après diffusion, d'obtenir des résistances de couche de 10 $\Omega/\square$ nécessaires pour ce genre d'élément.

La diffusion fournissant la couche enterrée 3 est effectuée de façon à restaurer les défauts provoqués par l'implantation et à former une mince couche d'oxyde 24, couche qui évite la perte d'arsenic (voir figure 7).

La figure 7 représente la plaquette à l'étape suivante, une couche de résine photosensible 25 recouvre les régions de couche enterrée de façon à limiter l'implantation du bore au niveau des ouvertures 22 des fondations de mur. Le masque photographique utilisé pour cette opération comporte les motifs des murs d'isolement légèrement agrandis comme précédemment; un agrandissement de 2 $\mu$ permet une tolérance de positionnement de $\pm 1$ $\mu$, mais exige que sur le premier masque les motifs des couches enterrées soient distants de plus de 2 $\mu$ de ceux des murs d'isolement. Cette contrainte permet cependant aux fondations d'isolement de rentrer en contact avec la couche enterrée par diffusion latérale s'il est nécessaire de réduire au maximum la dimension des caissons.

L'implantation de fondations 26 dopées au bore est alors effectuée, avec une énergie choisie de façon que les ions ne traversent ni la couche de résine, ni la couche d'oxyde plus épaisse ayant crû initialement. Une couche d'oxyde de 1 $\mu$ et une énergie de 200 keV permettent de placer le bore assez profondément pour éviter son exodiffusion lors de l'épitaxie. La couche d'oxyde mince (50 nm) créée lors du recuit de la couche enterrée peut être éliminée soit avant, soit après l'implantation suivant la dose de bore implantée, elle est de toute façon d'épaisseur trop faible pour masquer l'implantation dans les conditions choisies.

Une dose de bore de $5 \times 10^{15}$at./cm², par exemple, sera suffisante pour obtenir par diffusion une traversée complète de la couche épitaxiée sand que la couche enterrée ne remonte d'une façon trop sensible.

La figure 8 représente la plaquette après la croissance de la couche épitaxiée et la diffusions d'isolement. Les fondations 26 ont donné naissance à des murs d'isolement 30 de type P qui délimitent dans la couche épitaxiée de type N des caissons isolés.

Selon le procédé de la présente invention, la distance entre les murs d'isolement et la couche enterrée peut donc être étroitement contrôlée: ces murs peuvent être disposés de la façon illustrée schématiquement en figure 8, ou bien ils peuvent être strictement adjoints à la couche enterrée, ou bien encore, comme cela est illustré en figure 9, les jonctions des murs d'isolement peuvent pénétrer de façon symétrique dans la diffusion latérale de la couche enterrée.

Les caractéristiques de la présente invention exposées ci-dessus permettent d'aligner avec précision les positions des murs d'isolement par rapport à celles des couches enterrées. Mais, pour que l'avantage ainsi obtenu soit effectif et pour atteindre l'objet de la présente invention, il importe que l'on puisse "voir" la position du faîte des murs d'isolement pour permettre l'alignement des photogravures ultérieures effectuées dans chaque caisson.

Pour faire apparaître le faîte des murs on peut procéder de deux façons: soit en creusant, par attaque chimique sélective selon le type de conductivité, le faîte des murs d'isolement P (Fig. 10), soit en transformant le silicium qui les constitue en silicium poreux par attaque anodique. Les deux procédés ont été essayés avec succès. Le second procédé est particulièrement utile dans les cas de structures telles que celle de la figure 9. Il est alors souhaitable de transformer le silicium poreux des murs en oxyde 28 (Fig. 11) si l'on ne veut pas réduire d'une façon excessive la tenue en tension d'isolement du caisson. On obtient alors un caisson isolé latéralement par oxyde, disposition qui permet, comme cela est bien connu, de réduire les dimensions des éléments et leur distance aux murs d'isolement du caisson.

Pour que l'isolement latéral soit de bonne qualité, il est nécessaire de contrôler la porosité du silicium lors de l'anodisation de façon à limiter les contraintes qui résultent de l'oxydation ultérieure.

Le procédé décrit permet donc notamment d'obtenir un isolement diélectrique latéral aligné à la périphérie des couches enterrées; cette disposition permet en particulier de réaliser des dispositifs comportant simultanément des caissons dont le fond est isolé soit par la jonction entre le substrat et la couche épitaxiée, soit par celle de la couche enterrée précédemment décrit et du substrat.

La figure 12 représente deux caissons adjacents 30 et 31 formés selon la présente invention. Le caisson 30 ne comprend pas de couche enterrée et contient un transistor PNP — substrat classique. Le caisson 31 comprend une couche enterrée 32 dont les bords viennent contacter les fondations de murs d'isolement en silice. Le caisson 31 contient un transistor NPN classique.

Lorsqu'on utilise simultanément ces deux types de transistor une difficulté généralement rencontrée provient du fait que le fonctionnement du transistor PNP dont le collecteur est formé par le substrat est perturbé par le transistor PNP parasite dont l'émetteur est constitué par la base du transistor NPN.

Dans les procédés classiques le gain du transistor parasite PNP ainsi constitué dépend grandement de la distance entre la fondation d'isolement et la couche enterrée puisque dans cet espace le fonctionnement est identique à celui d'un transistor PNP substrat authentique. Il est alors évident que toutes variations relatives de l'isolement et de la couche enterrée conduiront à des variations importantes du gain de cet élément parasite et donc à des mauvais fonctionnements du circuit intégré lui-même. Le procédé décrit précédemment permet de contrôler exactement cette distance isolement/couche enterrée et donc le gain des transistors parasites.

Une autre application de la présente invention est illustrée en figure 13 qui représente les caissons 40 munis de couches enterrées 41, adjacentes à des murs d'isolement 33 en oxyde de silicium. Dans ce cas l'élément conduisant à un courant parasite dans le substrat peut être une diode métal/semiconducteur (42/43) dite diode Schottky. Ce genre de disposition est fréquemment rencontré dans les mémoires bipolaires programmables. Ces mémoires sont constituées d'une matrice de diodes Schottky, matrice dans laquelle l'accès à chaque diode est formé par une connexion métallique non représentée et pouvant être fondue pour une intensité élevée. Lors de la programmation d'un point mémoire, on comprend aisément que le courant qui circulerait à l'extérieur du caisson de la diode adressée pourrait provoquer des inscriptions parasites. Là encore la possibilité d'autoaligner les murs d'isolement sur les couches enterrées permet de réaliser des points mémoires de très petites dimensions et d'un fonctionnement très sûr. Ces deux exemples mettent en évidence l'intérêt de l'invention. On comprendra de plus que l'exemple de réalisation qui est proposé n'est pas limitatif: on pourrait par exemple pour des caissons d'épaisseur très faible ($<1\ \mu$) au lieu de déposer la couche épitaxiée à température élevée par décomposition chimique d'un composé hydrogéné ou chloré de silicium, déposer ce silicium sous une forme amorphe à beaucoup plus basse température, un recuit superficiel grâce à un laser ou à un faisceau d'électrons conduisant simultanément à une recristallisation épitaxique de la couche et à la diffusion des isolements.

## Revendications

1. Procédé d'alignement de photogravures par rapport aux murs d'isolement de caissons dans des circuits intégrés, ces caissons étant formés dans une couche (4) d'un premier type de conductivité d'une épaisseur de 1 à 3 microns obtenue par croissance épitaxiale sur un substrat (1) du deuxième type de conductivité dans lequel sont implantées dans des zones correspondant au fond des caissons, des impuretés dopantes (12) du premier type de conductivité, ces caissons étant limités latéralement par des murs d'isolement; ce procédé consistant à implanter des impuretés dopantes (26) du deuxième type de conductivité dans le substrat selon le contour des murs d'isolement, puis, après formation de la couche épitaxiale, à faire diffuser ces impuretés vers et jusqu'à la surface de la couche épitaxiée, caractérisé en ce qu'il comprend, en outre l'étape consistant à rendre visible la zone d'affleurement superficielle des murs d'isolement.

2. Procédé selon la revendication 1 caractérisé en ce qu'il consiste à anodiser les plaquettes pour transformer les murs d'isolement en silicium monocristallin dopé du même type de conductivité que le substrat en silicium poreux, puis à procéder à un traitement oxydant pour transformer le silicium poreux en silice (Fig. 11).

3. Procédé selon la revendication 2 caractérisé en ce que les fondations des murs d'isolement sont disposées pour venir latéralement en contact avec la périphérie de la couche enterrée du premier type de conductivité, après diffusion.

4. Procédé selon la revendication 1 caractérisé en ce qu'il consiste à soumettre la surface de la plaquette à une attaque chimique, sélective selon le type de conductivité (Fig. 10).

5. Procédé selon la revendication 1 caractérisé en ce que les premières impuretés dopantes sont de l'arsenic et les deuxièmes du bore.

6. Utilisation du procédé selon la revendication 3 à la formation de caissons contenant des transistors NPN, voisins de caissons contenant des transistors PNP-Substrat.

## Patentansprüche

1. Verfahren zum Ausrichten von Photomasken bezüglich der Isolationsmauern von Kästen in integrierten Schaltkreisen, wobei diese Kästen in einer zwischen 1 und 3 $\mu$m dicken Schicht (4) eines ersten Leitfähigkeitstyps ausgebildet werden, die durch Epitaxialwachsen auf einem Substrat (1) eines zweiten Leitfähigkeitstyps erhalten wird, wobei in dem Boden der Kästen entsprechenden Zonen des Substrats Dotierungsunreinheiten (12) des ersten Leitfähigkeitstyps implantiert sind und die Kästen seitlich durch Isolationsmauern begrenzt sind, und wobei das Verfahren darin besteht, daß man Dotierungsunreinheiten (26) des zweiten Leitfähigkeitstyps in das Substrat entlang den Umrissen der Isolationsmauern implantiert, dann nach der Bildung der Epitaxialschicht diese Unreinheiten in Richtung auf und bis zur Oberfläche der epitaxiierten Schicht diffundieren läßt, dadurch gekennzeichnet, daß es außerdem den Verfahrensschritt aufweist, der darin besteht, daß man die Oberflächenzone sichtbar macht, in der die Isolationsmauern zutage treten.

2. Verfahren nach Anspruch 1, dadurch gekennzeichnet, daß die Plättchen anodisiert werden, wodurch die Isolationsmauern in monokristallines Silizium verwandelt werden, das gemäß demselben Leitfähigkeitstyp wie das Substrat aus porösem Silizium dotiert ist, und daß dann eine oxidierende behandlung erfolgt, bei der das poröse Silizium in Siliziumdioxid umgewandelt wird (Fig. 11).

3. Verfahren nach Anspruch 2, dadurch gekennzeichnet, daß die Basen der Isolationsmauern so angeordnet sind, daß sie seitlich den Umfang der eingelassenen Schicht des ersten Leitfähigkeitstyps nach der Diffusion berühren.

4. Verfahren nach Anspruch 1, dadurch gekennzeichnet, daß die Oberfläche des Plättchens einem chemischen Angriff ausgesetzt wird, der vom Leitfähigkeitstyp selektiv abhängt (Fig. 10).

5. Verfahren nach Anspruch 1, dadurch gekennzeichnet, daß die ersten Dotierungsunreinhieten aus Arsen und die zweiten aus Bor bestehen.

6. Verwendung des Verfahrens nach Anspruch 3 bei der Bildung von Kästen, die NPN-Transistoren enthalten, in der Nähe von Kästen, die PNP-Substrat-Transistoren enthalten.

## Claims

1. A method for aligning photomasks with reference to isolation walls of caissons in integrated circuits, these caissons being built up in a layer (4) of a first type of conductivity having a thickness of between 1 and 3 $\mu$m and being obtained by epitaxial growth on a substrate (1) of a second conductivity type, doping impurities (12) of the first conductivity type being implanted in zones of the substrate which correspond to the bottom of the caissons, these caissons being bound laterally by isolation walls, the method consisting in the implantation of doping impurities (26) of the second conductivity type into the substrate along the contour line of the isolation walls, then, after the epitaxial layer has been built up, in the diffusion of these impurities in the direction of and up to the surface of the epitaxial layer, characterized in that it comprises in addition the step consisting in rendering the zone visible in which the isolation walls appear at the surface.

2. A method according to claim 1, characterized in that it consists in anodizing the plates in order to transform the isolation walls into monocristallic silicium which is doped according to the same conductivity type as the substrate made of porous silicium, and then in proceeding to an oxidizing treatment in order to transform the porous silicium into silica (Fig. 11).

3. A method according to claim 2, characterized in that the basements of the isolation walls are disposed in a manner so as to touch laterally the periphery of the embedded layer of the first conductivity type, after diffusion.

4. A method according to claim 1, characterized in that it consists in submitting the surface of the plate to a chemical attack which is selective according to the conductivity type (Fig. 10).

5. A method according to claim 1, characterized in that the first doping impurities are constituted by arsenic and the second ones by bore.

6. The use of the method according to claim 3, in building up caissons which contain transistors of the NPN type in the neighbourhood or caissons containing transistors of the PNP-substrate type.

FIG_1

FIG_2

FIG_3

FIG_4

FIG_5

FIG_6

FIG_7

FIG_8

FIG_9

FIG.10

FIG.11

FIG.12

FIG.13